# DEMANDE DE BREVET EUROPEEN

(11) **EP 2 824 708 A1**
(43) Date de publication de la demande: **14.01.2015**
(21) Numéro de dépôt: 14175693.2
(22) Date de dépôt: 03.07.2014
(51) Int. Cl.: H01L 27/115, H01L 29/788, G11C 16/04

(54) **Cellule de mémoire non volatile, procédé pour programmer, effacer et lire une telle cellule et dispositif de mémoire non volatile**

(30) Priorité: 11.07.2013 FR 1356836
(71) Demandeur: SemiConsultor, 83470 Saint-Maximin-La-Sainte-Baume (FR)
(72) Inventeur: Toren, Willem-Jan, 83470 SAINT-MAXIMIN-LA-SAINTE-BAUME (FR)
(74) Mandataire: Debay, Yves

(57) **Abrégé**

L'invention se rapporte à une cellule mémoire non volatile, caractérisée en ce qu'elle comprend :
- au moins un substrat de silicium dopé (4), un composant isolé (20) étant inséré dans une tranchée fabriquée dans ledit substrat (4), la tranchée séparant partiellement le substrat en deux sections (41, 42),
- au moins deux couches de silicium (52, 51) dont le dopage est opposé à celui du substrat de silicium (4), une première couche de silicium (51) couvrant au moins en partie la première section (41) du substrat de silicium et une seconde couche de silicium (52) couvrant au moins en partie la seconde section (52) du substrat de silicium, la première couche de silicium (51) étant discontinue afin de former une région de source (511) et une région de drain (510) avec un canal induit entre celles-ci,
- une région de source (80) et une région de drain (81) avec un canal induit entre les deux régions, une de ces régions étant adjacente à la première couche de silicium (51), une structure de grille comprenant une couche diélectrique (70) et une couche conductrice (71) étant placée au moins sur le canal, le substrat de silicium (4), les régions de source (80) et de drain (81) et la structure de grille formant un transistor de sélection pour permettre le flux d'électrons au moins dans la première couche de silicium (51),
- une structure de grille flottante sur les deux couches de silicium (52, 51), ladite structure comprenant une couche diélectrique mince (60) et une couche conductrice (61), au moins une partie des couches diélectrique (60) et conductrice (61) placée sur la première couche de silicium (51) ayant une forme de marche d'escalier afin d'améliorer l'injection d'électrons dans la couche conductrice (60) de la structure de grille flottante ou dans la première couche de silicium (51), en fonction de la manière dont la couche conductrice de la grille flottante et la première couche de silicium sont polarisées.

## Description

### DOMAINE TECHNIQUE

L'invention concerne les mémoires non volatiles programmables et/ou effaçables électriquement. Plus précisément, l'invention concerne une cellule de mémoire non volatile dont la structure permet sa programmation et/ou son effacement électriques plus efficaces avec des potentiels inférieurs, et avec une conservation en mémoire améliorée. L'invention concerne également un dispositif de mémoire non volatile et un procédé pour programmer et effacer électriquement de telles cellules de mémoire grâce à l'effet tunnel Fowler-Nordheim.

### ARRIÈRE-PLAN

Les mémoires non volatiles existent depuis de nombreuses années dans nombre de domaines liés à l'électronique et/ou à l'informatique. Ces mémoires permettent le stockage d'informations, même lorsque le dispositif de mémoire n'est pas alimenté. La technologie derrière ces mémoires est effectuée par des transistors à effet de champ, et plus particulièrement des transistors à effet de champ à grille flottante ou FGFET. En effet, la programmation de cellules de mémoire comprenant des FGFET consiste à injecter des électrons dans la grille flottante des FET des cellules de mémoire. D'autre part, l'effacement d'une cellule de mémoire consiste en la réduction du nombre d'électrons présents dans la grille flottante de chaque FET. Etant donné que la grille flottante est isolée électriquement dans le FET, lorsqu'aucune énergie n'est fournie au FET, les électrons ont tendance à rester dans la grille flottante. L'inconvénient de cette technologie est le besoin de haut potentiel électrique pour programmer et effacer une cellule de mémoire, afin de permettre l'injection d'électrons par effet tunnel. Par exemple, ces hauts potentiels peuvent interférer dans la programmation des cellules voisines. Également, l'utilisation répétée de tels hauts potentiels peut réduire la durée de vie de composants.

La demande de brevet US n° 4 203 158 décrit un dispositif de mémoire MOS programmable électriquement et effaçable électriquement approprié pour des mémoires de circuit intégré à haute densité. Des porteurs circulent par effet tunnel entre une grille flottante et une région dopée du substrat pour programmer et effacer le dispositif : une aire minimum de couche d'oxyde mince est utilisée pour séparer la région dopée de la grille flottante. Un inconvénient du dispositif de mémoire décrit dans cette demande est que la couche d'oxyde n'a pas une épaisseur constante. Donc une difficulté de production se présentera probablement. Un autre inconvénient est la nécessité d'utiliser des très hauts potentiels électriques pour programmer et pour effacer le dispositif de mémoire.

La demande de brevet US n°5 029 130 décrit une cellule de mémoire programmable et effaçable électriquement à un seul transistor. Le seul transistor a une source, un drain avec un canal entre ceux-ci, définis sur un substrat. Une première couche isolante est sur les régions de source, de canal et de drain. Une grille flottante est positionnée au-dessus de la première couche isolante sur une partie de la région de canal et sur une partie de la région de drain. Une seconde couche isolante et ensuite une grille de commande sont sur la grille flottante. L'effacement de la cellule est accompli par le mécanisme de l'effet tunnel Fowler-Nordheim depuis la grille flottante en passant par la seconde couche isolante jusqu'à la grille de commande. La programmation est accomplie par la migration d'électrons depuis la source à travers la région de canal au-dessous de la grille de commande, et ensuite à travers la première couche isolante dans la grille flottante suite à une chute de potentiel abrupte. Toutefois, le transistor décrit dans cette demande comprend une grille flottante et une grille de commande. Cette demande ne peut pas s'appliquer avec des transistors ne comprenant qu'une grille flottante.

La demande de brevet US n°6 157 058 décrit une configuration de dispositif FET pour les mémoires programmables et effaçables électriquement, qui ajoute des composants verticaux à une structure de cellule à grille flottante précédemment plane. L'efficacité de l'injection d'électrons du canal vers la grille flottante est alors améliorée par de nombreux ordres de grandeur parce que les électrons accélérés dans le canal pénètrent dans la direction de mouvement, droit dans la grille flottante. En conséquence, une haute efficacité d'injection peut être atteinte à des tensions de fonctionnement bien inférieures, et le temps de programme est diminué, ce qui a été un facteur limitant dans les applications EEPROM. Toutefois, même si la forme de la structure de grille flottante a été conçue pour faciliter l'injection d'électrons chauds du canal du transistor vers la grille flottante, elle n'améliore pas le mouvement d'électrons de la grille flottante au canal. Donc, il ne semble pas que le dispositif de mémoire décrit dans cette demande améliore la conservation en mémoire.

### DESCRIPTION DE L'INVENTION

La présente invention est par conséquent destinée à fournir une cellule de mémoire non volatile, qui surmonte un ou plusieurs des inconvénients de l'art antérieur. La présente invention fournit une cellule de mémoire non volatile et un dispositif de mémoire non volatile s'exécutant à une faible tension de programmation et d'effacement, avec une très bonne conservation en mémoire. Donc la fiabilité et la taille de la cellule de mémoire sont améliorées.

L'invention se rapporte à une cellule de mémoire non volatile, caractérisée en ce qu'elle comprend :
- au moins un substrat de silicium dopé, un composant isolé étant inséré dans une tranchée fabriquée dans ledit substrat, la tranchée séparant partiellement le substrat en deux sections,
- au moins deux couches de silicium dont le dopage est opposé à celui du substrat de silicium, une première couche de silicium couvrant au moins en partie la première section du substrat de silicium et une seconde couche de silicium couvrant au moins en partie la seconde section du substrat de silicium, la première couche de silicium étant discontinue afin de former une région de source et une région de drain avec un canal induit entre celles-ci,
- une région de source et une région de drain avec un canal induit entre les deux régions, une de ces régions étant adjacente à la première couche de silicium, une structure de grille comprenant une couche diélectrique et une couche conductrice étant placée au moins sur le canal, le substrat de silicium, les régions de source et de drain et la structure de grille formant un transistor de sélection pour permettre le flux d'électrons au moins dans la première couche de silicium,
- une structure de grille flottante sur les deux couches de silicium, ladite structure comprenant une couche diélectrique mince et une couche conductrice, au moins une partie des couches diélectrique et conductrice placée sur la première couche de silicium ayant une forme de marche d'escalier afin d'améliorer l'injection d'électrons dans la couche conductrice de la structure de grille flottante ou dans la première couche de silicium, en fonction de la manière dont la couche conductrice de la grille flottante et la première couche de silicium sont polarisées.

Selon une autre caractéristique, la cellule de mémoire non volatile est caractérisée en ce que les sections du substrat de silicium dopé sont deux sections séparées électriquement se trouvant sur une région dont le dopage est opposé à celui du substrat, lesdites sections étant séparées par le composant isolé de sorte que les deux sections puissent être polarisées différemment.

Selon une autre caractéristique, la cellule de mémoire non volatile est caractérisée en ce que la première section du substrat de silicium dopé a une forme de marche d'escalier.

Selon une autre caractéristique, la cellule de mémoire non volatile est caractérisée en ce que l'angle de la forme de marche d'escalier formé dans la couche diélectrique de la structure de grille flottante est compris entre 30° et 90° lorsque mesuré depuis une direction parallèle à la surface du substrat.

Selon une autre caractéristique, la cellule de mémoire non volatile est caractérisée en ce que l'angle de la forme de marche d'escalier forme un Z.

Selon une autre caractéristique, la cellule de mémoire non volatile est caractérisée en ce que la seconde couche de silicium est un conducteur électrique d'un condensateur, l'autre conducteur électrique étant la couche conductrice de la structure de grille flottante.

Selon une autre caractéristique, la cellule de mémoire non volatile est caractérisée en ce que le substrat de silicium est un puits dopé P.

Selon une autre caractéristique, la cellule de mémoire non volatile est caractérisée en ce que les régions de drain et de source du transistor de sélection sont dopées N+.

Selon une autre caractéristique, la cellule de mémoire non volatile est caractérisée en ce que les deux sections du substrat de silicium et le composant isolé se trouvent sur une région de puits dopée N profonde afin d'isoler électriquement les deux sections du substrat de silicium.

Selon une autre caractéristique, la cellule de mémoire non volatile est caractérisée en ce que les couches de silicium sont faites juste avant le dépôt de la couche conductrice de la structure de grille flottante, lesdites couches de silicium étant dopées N+.

Selon une autre caractéristique, la cellule de mémoire non volatile est caractérisée en ce qu'une région de puits dopée N est formée entre le composant isolé et la région de puits dopée N profonde, ladite région de puits dopée N étant également comprise entre les deux sections du substrat de silicium de puits dopé P.

Selon une autre caractéristique, la cellule de mémoire non volatile est caractérisée en ce que la couche conductrice de la structure de grille et la couche conductrice de la structure de grille flottante sont en silicium polycristallin.

Selon une autre caractéristique, la cellule de mémoire non volatile est caractérisée en ce que le composant isolé, la couche diélectrique de la structure de grille et la couche diélectrique de la structure de grille flottante sont en oxyde de silicium.

Selon une autre caractéristique, la cellule de mémoire non volatile est caractérisée en ce que l'épaisseur de la couche diélectrique d'au moins la structure de grille flottante est constante, la valeur de l'épaisseur étant comprise entre 80 et 200 angströms.

Selon une autre caractéristique, la cellule de mémoire non volatile est caractérisée en ce que l'épaisseur et la forme de marche d'escalier de la couche diélectrique de la structure de grille flottante permettent la diminution de la tension de programmation de la couche conductrice de la structure de grille flottante.

Un autre but de cette invention est de proposer un procédé pour fabriquer une cellule de mémoire non volatile, le procédé étant caractérisé en ce qu'il comprend les étapes suivantes :
a. fournir un substrat de silicium dopé P, appelé le substrat de base,
b. former une région de puits dopée N profonde sur le substrat de base de silicium dopé P fourni,
c. former une région de puits dopée P sur la région de puits dopée N profonde, ladite région de puits dopée P étant isolée électriquement du substrat de base grâce à la région de puits dopée N profonde,
d. fabriquer une tranchée afin de diviser physiquement la région de puits dopée P formée sur la région de puits dopée N profonde en deux régions de puits dopées P, chaque région de puits dopée P étant appelée respectivement la première et la seconde section,
e. insérer un élément diélectrique à l'intérieur de la tranchée afin d'isoler électriquement les régions de puits dopées P l'une par rapport à l'autre,
f. former au moins deux couches de silicium dopées N+, la première couche de silicium couvrant au moins en partie la première section de la région de puits dopée P et la seconde couche de silicium couvrant au moins en partie la seconde section de la région de puits dopée P,
g. fabriquer une structure de grille, premièrement en déposant une couche diélectrique sur la première section de la région puits dopée P où aucune couche de silicium dopée N+ n'est présente, et deuxièmement en déposant une couche conductrice de silicium polycristallin sur la couche diélectrique,
h. fabriquer une structure de grille flottante, premièrement en déposant une couche diélectrique sur les deux couches de silicium dopées N+, et deuxièmement en déposant une couche conductrice de silicium polycristallin sur la couche diélectrique,
i. implanter deux régions de source/drain N+ sur la première section du substrat de puits dopé P, une région de source/drain N+ étant adjacente à la première couche de silicium dopée N+, la structure de grille et les deux régions de source/drain N+ formant un transistor de sélection.

Selon une autre caractéristique, le procédé pour fabriquer la cellule de mémoire non volatile est caractérisé en ce que la structure de grille et la structure de grille flottante sont fabriquées en même temps.

Un autre but de cette invention est de proposer un procédé pour programmer une cellule de mémoire non volatile, la cellule étant connectée à des moyens informatiques commandant ladite cellule et un générateur de puissance connecté à la cellule, caractérisé par l'injection d'électrons de la première couche de silicium vers la couche conductrice de la structure de grille flottante à travers le haut de la marche d'escalier de la couche diélectrique, le procédé comprend l'étape d'application d'un potentiel positif à la seconde couche de silicium grâce au générateur de puissance connecté à ladite couche, induisant la polarisation de la couche conductrice de la structure de grille flottante via un effet de couplage capacitif.

Selon une autre caractéristique, le procédé pour programmer la cellule de mémoire non volatile, les deux sections du substrat de silicium étant séparées électriquement, est caractérisé en ce que le procédé comprend une étape additionnelle consistant à appliquer un potentiel négatif à la première section du substrat de silicium et à la région de drain du transistor de sélection grâce au générateur de puissance connecté à ladite première section du substrat de silicium et à la région de drain du transistor de sélection, induisant le flux d'électrons de la région de drain vers la région de source du transistor de sélection, ledit flux d'électrons polarisant négativement la région de drain formée dans la première couche de silicium adjacente à la région de source du transistor de sélection.

Un autre but de cette invention est de proposer un procédé pour effacer une cellule de mémoire non volatile, la cellule étant connectée à des moyens informatiques commandant ladite cellule et un générateur de puissance connecté à la cellule, caractérisé par l'injection d'électrons de la couche conductrice de la structure de grille flottante vers la première couche de silicium à travers le bas de la marche d'escalier de la couche diélectrique, le procédé comprend l'étape d'application d'un potentiel positif à la couche conductrice de la structure de grille et à la région de drain du transistor de sélection grâce au générateur de puissance connecté à ladite couche conductrice de la structure de grille et à la région de drain du transistor de sélection, induisant la polarisation positive de la région de drain formée dans la première couche de silicium adjacente à la région de source du transistor de sélection.

Selon une autre caractéristique, le procédé pour effacer la cellule de mémoire non volatile, les deux sections du substrat de silicium étant séparées électriquement, est caractérisé en ce que le procédé comprend une première étape consistant à appliquer un potentiel négatif à la seconde couche de silicium et à la seconde section du substrat de silicium grâce au générateur de puissance connecté à ladite couche et à la section du substrat de silicium, induisant la polarisation de la couche conductrice de la structure de grille flottante via un effet de couplage capacitif.

Un autre but de cette invention est de proposer un procédé pour lire une cellule de mémoire non volatile, caractérisé par la mesure du potentiel électrique de la couche conductrice de la structure de grille flottante grâce au transistor de lecture, la région de drain et la couche conductrice du transistor de sélection étant polarisées positivement grâce au générateur de puissance connecté à la fois à la région de drain et à la couche conductrice du transistor de sélection.

Un autre but de cette invention est de proposer un dispositif de mémoire non volatile, caractérisé en ce qu'il comprend une pluralité de cellules de mémoire non volatile interconnectées selon l'invention.

L'invention, ses caractéristiques et avantages, deviendront plus clairs à la lecture de la description suivant en référence aux dessins dans lesquels :
la figure 1a représente une vue en coupe d'une cellule de mémoire non volatile concernant l'invention dans un mode de réalisation.
La figure 1b représente une vue en coupe d'une cellule de mémoire non volatile concernant l'invention dans un autre mode de réalisation.
La figure 1c représente un schéma d'une cellule de mémoire non volatile concernant l'invention.
La figure 2 représente une vue de dessus de trois cellules de mémoire non volatile connectées ensemble.
La figure 3a représente un champ électrique généré près de la forme de marche d'escalier lors de la polarisation de la structure de grille flottante et de la première couche de silicium dopée pour programmer la cellule de mémoire non volatile.
La figure 3b représente un champ électrique généré près de la forme de marche d'escalier lors de la polarisation de la structure de grille flottante et de la première couche de silicium dopée pour effacer la cellule de mémoire non volatile.
La figure 4 représente un schéma d'une matrice d'une pluralité de cellules de mémoire non volatile, formant un dispositif de mémoire non volatile concernant l'invention.

### DESCRIPTION DE MODES DE RÉALISATION PRÉFÉRÉS DE L'INVENTION

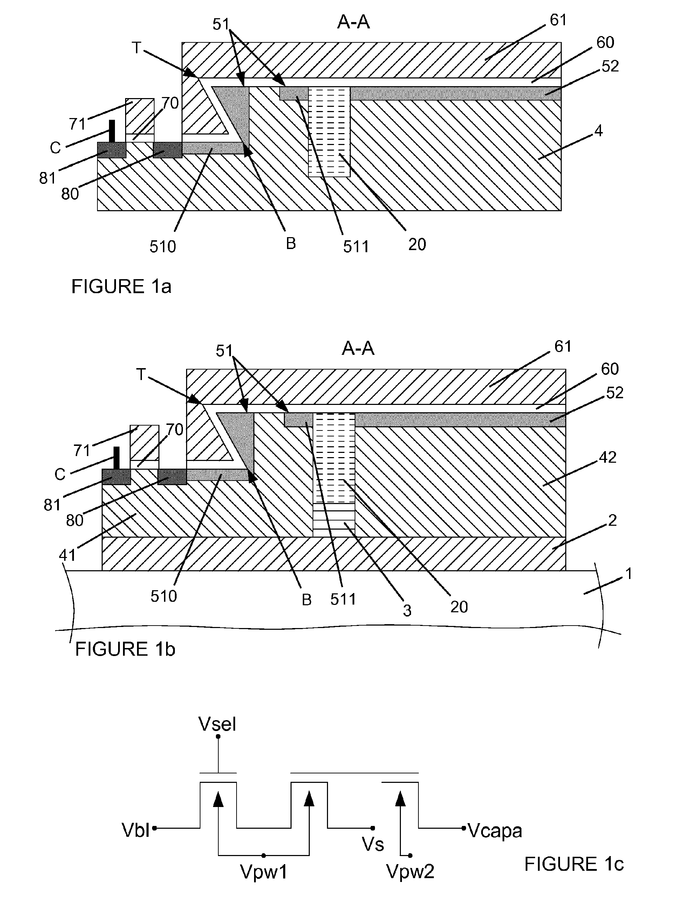

En référence aux figures 1 à 4, l'invention va maintenant être décrite.

Dans un mode de réalisation, la cellule de mémoire non volatile est fabriquée sur un substrat de base dopé (1), par exemple en silicium. Par exemple, et de manière non limitative, ce substrat de base (1) est dopé P.

Dans un mode de réalisation, la cellule de mémoire non volatile comprend au moins un substrat de silicium dopé (4), ledit substrat de silicium étant de puits dopé N, de manière non limitative. Afin d'isoler électriquement le substrat de silicium de puits dopé P (4) du substrat de base dopé P (1), la cellule de mémoire non volatile comprend également, entre le substrat de base et le substrat de silicium, une région puits N profonde (2). Cette région est formée avant la formation du substrat de silicium de puits dopé P.

Dans un mode de réalisation concernant la figure 1b, le substrat de silicium de puits dopé P (4) comprend deux sections séparées électriquement physiquement (41, 42). Pour ce faire, une tranchée est fabriquée à travers le substrat de silicium (4), par exemple en attaquant chimiquement le substrat de silicium. Ensuite, un composant isolé (20) est inséré dans cette tranchée. Une telle opération est effectuée suivant le processus d'isolation de tranchée peu profonde connu. Par exemple et de manière non limitative, le composant isolé (20) est un composant diélectrique, par exemple en oxyde de silicium. Donc il y a deux sections de puits dopées P différentes (41, 42) faites dans le substrat de silicium de puits dopé P (4), lesdites sections étant isolées électriquement l'une par rapport à l'autre. Dans ce qui suit, ces deux sections du substrat de silicium de puits dopé P seront appelées la première section de puits dopée P (41) et la seconde section de puits dopée P (42). Les deux sections dopées étant séparées électriquement, elles peuvent être polarisées différemment grâce à un générateur de puissance, par exemple et de manière non limitative un générateur électrique.

Dans un autre mode de réalisation relatif à la figure 1a, étant donné que les sections de puits dopées P (41, 42) faites dans le substrat de silicium de puits dopé P (4) ne sont pas séparées électriquement, il n'est pas utile de fournir un substrat de base (1) et une région de puits N profonde (2).

Dans un mode de réalisation relatif à la figure 1b, une région de puits N (3) est formée entre la région de puits N profonde (2) et le composant isolé (20). Cette région de puits N prend place entre les deux sections (41, 42) du substrat de silicium de puits dopé P, et une isolation améliorée entre lesdites deux sections (41, 42).

Dans un mode de réalisation, la cellule de mémoire non volatile comprend au moins deux couches de silicium (52, 51) qui sont formées au-dessus de chaque section du substrat de silicium (4). Dans un mode de réalisation, mais de manière non limitative, une première couche de silicium (51) est formée dans la première section (41) du substrat de silicium, la première couche couvrant en partie la première section, et une seconde couche de silicium (52) est formée dans la seconde section (42) du substrat de silicium, la seconde couche couvrant au moins en partie la seconde section. Les couches de silicium (52, 51) sont fortement dopées, et leur dopage est opposé à celui du substrat de silicium (4). Dans un mode de réalisation préféré, mais de manière non limitative, les couches de silicium sont dopées N+.

Dans un mode de réalisation, la première couche de silicium dopée N+ (51) est discontinue afin de former une région de source (511) et une région de drain (510) avec un canal induit entre celles-ci, afin de former, avec au moins une partie de la structure de grille flottante, un transistor de lecture appelé FET afin de mesurer le potentiel électrique de la couche conductrice (61) de la structure de grille flottante. Le rôle de ce transistor de lecture sera expliqué plus loin dans le texte de la description.

Dans un mode de réalisation, la cellule de mémoire non volatile comprend une région de source (80) et une région de drain (81), avec un canal induit entre les deux régions, et une de ces régions est adjacente à la première couche de silicium (51). Ces régions de drain/source (80, 81) sont implantées dans la première section (41) du substrat de silicium. Dans un mode de réalisation préféré, et de manière non limitative, ces régions de source/drain sont dopées N+, étant donné que la première section (41) du substrat de silicium est de puits dopée P. La cellule de mémoire non volatile comprend également une structure de grille, ladite structure comprenant une couche isolée (70) et une couche conductrice (71) sur la couche isolée. La couche isolée, par exemple un composant diélectrique en oxyde de silicium, est déposée sur la première section (41) du substrat de silicium, où aucune couche de silicium dopée (51) n'est présente. Dans un autre mode de réalisation, la couche isolée, par exemple un composant diélectrique en oxyde de silicium, croît sur la première section (41) du substrat de silicium, où aucune couche de silicium dopée (51) n'est présente. Ensuite, une couche conductrice (71), par exemple en silicium polycristallin, est déposée sur la couche isolée (70). La structure de grille est déposée sur le canal induit, de sorte que les régions de source/drain (80, 81) et la structure de grille forment un transistor de sélection appelé FET pour permettre ou non le flux d'électrons au moins dans la première couche de silicium (51). La couche conductrice (71) de la structure de grille est connectée au générateur de puissance.

Dans un mode de réalisation, la cellule de mémoire non volatile comprend une structure de grille flottante, ladite structure comprenant une couche isolée (60) et une couche conductrice (61) sur la couche isolée. La couche isolée, par exemple un composant diélectrique en oxyde de silicium, est déposée sur la seconde couche de silicium (52), sur la seconde section (42) du substrat de silicium. Ensuite, une couche conductrice, par exemple en silicium polycristallin, est déposée sur la couche isolée. Par exemple et de manière non limitative, l'épaisseur des couches isolées (60, 70) de la structure de grille et des structures de grille flottante est comprise entre 50 et 500 angströms, de préférence entre 80 et 200 angströms, et de préférence encore autour de 80-100 angströms. Dans un mode de réalisation préféré, mais de manière non limitative, l'épaisseur des couches isolées de la structure de grille et des structures de grille flottante est constante.

Le dépôt de la structure de grille et de la structure de grille flottante est effectué avant l'implantation des régions de source/drain (80, 81) du transistor de sélection, alors que l'implantation des couches de silicium dopées (52, 51) est effectuée avant le dépôt de la structure de grille et de la structure de grille flottante. Par conséquent, il y a des régions dopées sous les structures de grille, qui sont par exemple et de manière non limitative, fortement dopées N+. De manière physique, ces couches de silicium dopées N+ (52, 51) sont implantées avant le dépôt des structures de grille. Par exemple et de manière non limitative, la structure de grille et la structure de grille flottante sont fabriquées en même temps.

Dans un mode de réalisation, au moins une extrémité de la couche diélectrique (60) placée sur la première couche de silicium (51) et placée près de la région de drain/source (80) a une forme de marche d'escalier afin d'améliorer l'injection d'électrons dans la couche conductrice (61) de la structure de grille flottante ou dans la première couche de silicium (51), en fonction de la manière dont la couche conductrice (61) de la structure de grille flottante et la première couche de silicium (51) sont polarisées grâce au générateur de puissance. Dans un mode de réalisation préféré mais de manière non limitative, la première section (41) du substrat de silicium (4) a une forme de marche d'escalier.

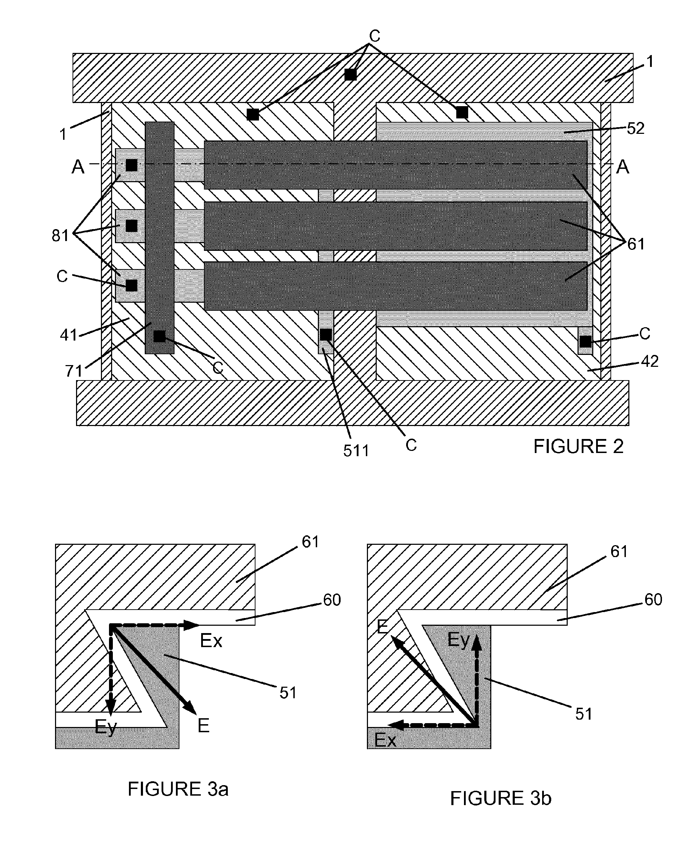

Dans un mode de réalisation, mais de manière non limitative, l'angle de la forme de marche d'escalier formé dans la couche diélectrique (60) de la structure de grille flottante est compris entre 30° et 90° lorsque mesuré depuis une direction parallèle à la surface du substrat. Dans un mode de réalisation préféré, l'angle de la forme de marche d'escalier forme un Z. Dans un autre mode de réalisation, l'angle de la forme de marche d'escalier formé dans la couche diélectrique (60) de la structure de grille flottante est supérieur à 90°. Cette forme particulière de la couche isolée (60) permet l'utilisation de potentiel électrique inférieur pour programmer ou effacer la cellule de mémoire non volatile. En effet, l'homme du métier sait bien que, pour programmer des transistors à effet de champ ayant une structure de grille flottante, de hauts potentiels sont nécessaires pour permettre l'injection d'électrons dans la grille flottante par effet tunnel à travers la couche diélectrique (60). Les fabricants rencontrent deux problèmes majeurs lors de la conception de cellules de mémoire non volatile et de dispositif de mémoire non volatile. D'une part, la couche diélectrique de la structure de grille flottante doit être suffisamment épaisse pour assurer la rétention d'électrons dans la couche conductrice de la structure de grille flottante lorsque la cellule de mémoire et/ou le dispositif de mémoire est programmé. D'autre part, lorsque la couche diélectrique de la structure de grille flottante est trop épaisse, de très hauts potentiels électriques sont requis pour permettre aux électrons de traverser la couche diélectrique via effet tunnel. Ces très hauts potentiels électriques peuvent perturber la programmation de cellules voisines, alors que la consommation de puissance est très élevée. En raison de la forme en Z (ou forme de marche d'escalier) de la couche isolée (60) de la structure de grille flottante, le champ électrique (E) au niveau du haut (T) ou au niveau du bas (B) de la forme de marche d'escalier est une sorte de sommation vectorielle de deux composantes du champ électrique (Ex, Ey), comme cela est représenté sur les figures 3a et 3b. Le résultat est que la même valeur du champ électrique peut être obtenue dans l'invention avec des potentiels électriques inférieurs à ceux utilisés dans l'art antérieur. Ce champ électrique est obtenu lorsque la couche conductrice (61) de la structure de grille flottante et la première couche de silicium dopée (51) sont polarisées par le générateur de puissance. Ceci sera détaillé plus loin dans le texte de la description.

Il est alors possible de programmer ou d'effacer des cellules de mémoire non volatile de l'invention avec des potentiels électriques plus petits que ceux utilisés dans l'art antérieur, alors que la couche diélectrique (60) de la structure de grille flottante de la cellule de mémoire reste aussi épaisse que les couches diélectriques utilisées dans l'art antérieur, ou est même un peu plus épaisse que les couches diélectriques utilisées dans l'art antérieur. En conséquence, la forme de marche d'escalier (ou forme en Z) de la couche isolée (60) de la structure de grille flottante de l'invention combine une meilleure fiabilité (l'utilisation de potentiel électrique plus petit est moins perturbante pour les cellules de mémoire voisines), une consommation de puissance plus petite et une meilleure rétention d'électrons dans la couche conductrice (61) de la structure de grille flottante.

Le procédé pour lire la cellule de mémoire non volatile concernant l'invention va maintenant être décrit dans un mode de réalisation préféré. La cellule de mémoire est à la fois connectée via des connecteurs (C) au moins au générateur de puissance et à des moyens informatiques : les moyens informatiques commandent le générateur de puissance et la cellule de mémoire.

L'étape du procédé pour lire la cellule de mémoire non volatile est la mesure du potentiel électrique de la couche conductrice (61) de la structure de grille flottante, grâce au transistor de lecture ; pour ce faire, la région de drain (81) et la couche conductrice (71) de la structure de grille du transistor de sélection sont polarisées positivement grâce au générateur électrique. L'homme du métier comprend que la région de drain (81) du transistor de sélection et la couche conductrice (71) de la structure de grille sont connectées au générateur électrique. Ainsi, le potentiel électrique de la couche conductrice (71) de la structure de grille du transistor de sélection est V_{SEL}, alors que le potentiel de la région de drain (81) du transistor de sélection est V_{BL}. Par exemple et de manière non limitative, V_{BL} et V_{SEL} sont polarisés à 4 volts. Bien évidemment, les première et seconde sections (41, 42) du substrat de silicium dopé sont également connectées au générateur de puissance, et leurs potentiels électriques sont respectivement V_{PW1} et V_{PW2}. Il en est de même pour la région de source (511) du transistor de lecture, dont le potentiel électrique est V_{S}. Au cours du procédé pour lire la cellule de mémoire non volatile, les première et seconde sections du substrat de silicium sont polarisées à 0V, et il en est de même pour la région de source (511) du transistor de lecture. Alors *V_{S}* = *V_{PW1}* = *V_{PW2}* = 0 volt.

Le procédé pour programmer la cellule de mémoire non volatile concernant l'invention va maintenant être décrit dans un mode de réalisation préféré, lorsque la première (41) et la seconde (42) section du substrat de silicium (4) sont séparées électriquement. La cellule de mémoire est à la fois connectée via des connecteurs (C) au moins au générateur de puissance et à des moyens informatiques : les moyens informatiques commandent le générateur de puissance et la cellule de mémoire.

La programmation de la cellule de mémoire non volatile est obtenue grâce à l'injection d'électron par effet tunnel de la première couche de silicium (51, 510) vers la couche conductrice (61) de la structure de grille flottante. Pour ce faire, une différence de potentiel électrique entre la couche conductrice (61) de la structure de grille flottante et la région de drain (510) formée dans la première couche de silicium (51) doit être suffisamment importante pour permettre le flux d'électrons à travers la couche diélectrique (60) de la structure de grille flottante.

La première étape du procédé pour programmer la cellule de mémoire non volatile est l'application d'un potentiel électrique positif à la seconde couche de silicium (52) de la cellule, ladite couche étant connectée au générateur de puissance. Le potentiel électrique de la seconde couche de silicium (52) est V_{CAPA}. La seconde couche de silicium est considérée être un conducteur électrique d'un condensateur, l'autre conducteur électrique étant la couche conductrice (61) de la structure de grille flottante. Ainsi, la polarisation de la couche conductrice de la structure de grille flottante est induite via un effet de couplage capacitif. Par exemple et de manière non limitative, la seconde couche de silicium (52) est polarisée à 4 volts, c'est-à-dire *V_{CAPA}* = 4 volts, induisant la polarisation positive de la couche conductrice (61) de la structure de grille flottante.

La seconde étape du procédé pour programmer la cellule de mémoire non volatile est l'application d'un potentiel électrique négatif à la fois à la première section (41) du substrat de silicium, par exemple et de manière non limitative *V_{PW1}* = -4 volts, et à la région de drain (81) du transistor de sélection, par exemple et de manière non limitative *V_{BL}* = -4 volts. Ces polarisations sont réalisées grâce au générateur de puissance connecté au transistor de sélection et à la première section (41) du substrat de silicium. Ceci induit un flux d'électron de la région de drain (81) vers la région de source (80) du transistor de sélection. La région de source (80) du transistor de sélection étant adjacente à la région de drain (510) formée dans la première couche de silicium (51), ladite couche est polarisée négativement grâce au flux d'électrons. Par exemple et de manière non limitative, le potentiel électrique de la première couche de silicium est de -4 volts.

Ainsi, la couche conductrice (61) de la structure de grille flottante est polarisée positivement, alors que la région de drain (510) formée dans la première couche de silicium (51) est polarisée négativement. Par exemple et de manière non limitative, la différence de potentiel entre la couche conductrice de la structure de grille flottante et la première couche de silicium est d'environ 8 volts. Grâce à la forme de marche d'escalier de la couche diélectrique de la structure de grille flottante, le champ électrique (E) au niveau du haut (T) de la marche est la somme de deux composantes (Ex, Ey), comme cela est représenté sur la figure 3a. Le champ électrique est suffisamment élevé pour permettre le flux d'électrons de la région de drain (510) formée dans la première couche de silicium (51) vers la couche conductrice (61) de la structure de grille flottante.

Au cours de la première et de la seconde étape, la couche conductrice (71) de la structure de grille du transistor de sélection et la seconde section (42) du substrat de silicium sont polarisées à 0V, donc *V_{SEL} = V_{PW2}* = 0 volt.

Dans un autre mode de réalisation, lorsque les deux sections (41, 42) du substrat de silicium ne sont pas séparées électriquement, le procédé pour programmer la cellule ne comprend que la première étape, qui est l'application d'un potentiel électrique positif à la seconde couche de silicium (52) de la cellule, ladite couche étant connectée au générateur de puissance. Dans cet autre mode de réalisation, les potentiels électriques sont différents : étant donné que les deux sections (41, 42) sont raccordées électriquement, *V_{SEL} = V_{PW1} = V_{PW2} =* 0, *V_{BL} =* 0 volt et *V_{CAPA}* = 8 volts par exemple et de manière non limitative.

Le procédé pour effacer la cellule de mémoire non volatile concernant l'invention va maintenant être décrit dans un mode de réalisation préféré, lorsque la première (41) et la seconde (42) section du substrat de silicium (4) sont séparées électriquement.

L'effacement de la cellule de mémoire non volatile est obtenu grâce à l'injection d'électron par effet tunnel de la couche conductrice (61) de la structure de grille flottante vers la région de drain (510) formée dans la première couche de silicium (51). Pour ce faire, une différence de potentiel entre la couche conductrice (61) de la structure de grille flottante et la première couche de silicium doit être suffisamment importante pour permettre le flux d'électrons à travers la couche diélectrique (60) de la structure de grille flottante.

La première étape du procédé pour effacer la cellule de mémoire non volatile est l'application d'un potentiel électrique négatif à la fois à la seconde section (42) du substrat de silicium et à la seconde couche de silicium (52) de la cellule, ladite couche et ladite seconde section étant connectées au générateur de puissance. La polarisation de la couche conductrice (61) de la structure de grille flottante est alors induite via un effet de couplage capacitif. Par exemple et de manière non limitative, la seconde couche de silicium et la seconde section du substrat de silicium sont polarisées à -4 volts, c'est-à-dire *V_{CAPA} = V_{PW2}* = -4 volts, induisant la polarisation négative de la couche conductrice (61) de la structure de grille flottante.

La seconde étape du procédé pour effacer la cellule de mémoire non volatile est l'application d'un potentiel électrique positif à la fois à la couche conductrice (71) de la structure de grille du transistor de sélection, par exemple et de manière non limitative *V_{SEL}* = 4 volts, et à la région de drain (81) du transistor de sélection, par exemple et de manière non limitative *V_{BL}* = 4 volts. Ces polarisations sont réalisées grâce au générateur de puissance connecté à la couche conductrice (71) de la structure de grille du transistor de sélection et à la région de drain (81) du transistor de sélection. Ceci induit une polarisation positive des régions de source/drain (80, 81) du transistor de sélection. La région de source (80) du transistor de sélection est adjacente à la région de drain (510) formée dans la première couche de silicium (51), ladite région de drain étant polarisée positivement grâce au flux d'électrons. Par exemple et de manière non limitative, le potentiel électrique de la première couche de silicium est de 4 volts.

Ainsi, la couche conductrice (61) de la structure de grille flottante est polarisée négativement, alors que la région de drain (510) formée dans la première couche de silicium (51) est polarisée positivement. Par exemple et de manière non limitative, la différence de potentiel entre la couche conductrice (61) de la structure de grille flottante et la région de drain (510) de la première couche de silicium (51) est d'environ 8 volts. Grâce à la forme de marche d'escalier de la couche diélectrique (60) de la structure de grille flottante, le champ électrique au niveau du bas (B) de la marche est la somme de deux composantes, comme cela est représenté sur la figure 3b. Le champ électrique est suffisamment élevé pour permettre le flux d'électrons de la couche conductrice (61) de la structure de grille flottante à la première couche de silicium (51).

Au cours de la première et de la seconde étape, la première section (41) du substrat de silicium est polarisée à 0V, donc *V_{PW1}* = 0 volt.

Dans un autre mode de réalisation, lorsque les deux sections (41, 42) du substrat de silicium ne sont pas séparées électriquement, le procédé pour programmer la cellule ne comprend que la seconde étape, qui est l'application d'un potentiel électrique positif à la fois à la couche conductrice (71) de la structure de grille du transistor de sélection et à la région de drain (81) du transistor de sélection, le générateur de puissance étant connecté à la couche conductrice (71) de la structure de grille du transistor de sélection et à la région de drain (81) du transistor de sélection. Dans cet autre mode de réalisation, les potentiels électriques sont différents : étant donné que les deux sections (41, 42) sont raccordées électriquement, *V_{PW1} = V_{PW2}* = 0, *V_{BL}* = *V_{SEL}* = 8 volts par exemple et de manière non limitative, et *V_{CAPA}* = 0 volt.

Lorsque les deux sections (41, 42) du substrat de silicium (4) sont séparées électriquement, les potentiels électriques nécessaires pour programmer et/ou effacer la cellule de mémoire non volatile sont bas comparativement à ceux utilisés dans l'art antérieur, grâce à la forme de marche d'escalier de la couche diélectrique (60) de la structure de grille flottante. Ceci entraîne une nouvelle configuration concernant l'état de la technique, étant donné qu'aucun transistor additionnel n'est nécessaire pour fournir une tension plus élevée afin de permettre l'effet tunnel pour les électrons.

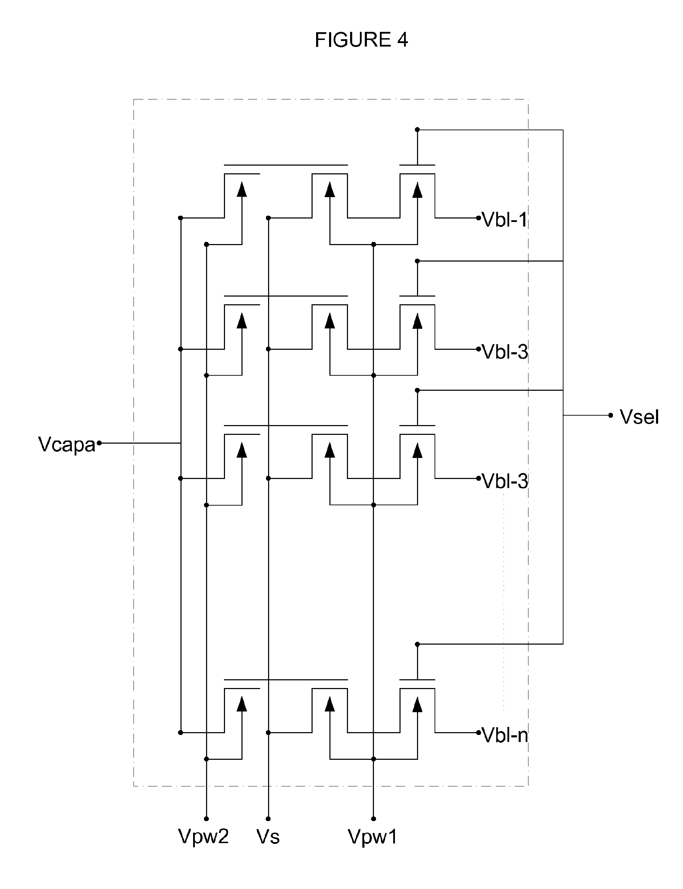

Dans un mode de réalisation, en référence aux figures 2 et 4, un autre objet de l'invention consiste à proposer un dispositif de mémoire non volatile, ledit dispositif comprenant une pluralité de cellules de mémoire non volatile interconnectées. Les cellules sont connectées en dérivation, et seule la région de drain (81) du transistor de sélection de chaque cellule est connectée individuellement au générateur de puissance.

La présente invention a été décrite concernant le mode de réalisation préféré. Il doit être compris que le type de régions de semi-conducteur, l'implantation du dispositif, et la polarité de tensions sont choisis uniquement pour l'illustration, et un homme du métier ordinaire reconnaîtra d'autres variantes, variations et modifications.

## Revendications

1. Cellule de mémoire non volatile, **caractérisée en ce qu'**elle comprend :
- au moins un substrat de silicium dopé (4), un composant isolé (20) étant inséré dans une tranchée fabriquée dans ledit substrat (4), la tranchée séparant partiellement le substrat en deux sections (41, 42),
- au moins deux couches de silicium (52, 51) dont le dopage est opposé à celui du substrat de silicium (4), une première couche de silicium (51) couvrant au moins en partie la première section (41) du substrat de silicium et une seconde couche de silicium (52) couvrant au moins en partie la seconde section (52) du substrat de silicium, la première couche de silicium (51) étant discontinue afin de former une région de source (511) et une région de drain (510) avec un canal induit entre celles-ci,
- une région de source (80) et une région de drain (81) avec un canal induit entre les deux régions, une de ces régions étant adjacente à la première couche de silicium (51), une structure de grille comprenant une couche diélectrique (70) et une couche conductrice (71) étant placée au moins sur le canal, le substrat de silicium (4), les régions de source (80) et de drain (81) et la structure de grille formant un transistor de sélection pour permettre le flux d'électrons au moins dans la première couche de silicium (51),
- une structure de grille flottante sur les deux couches de silicium (52, 51), ladite structure comprenant une couche diélectrique mince (60) et une couche conductrice (61), au moins une partie des couches diélectrique (60) et conductrice (61) placée sur la première couche de silicium (51) ayant une forme de marche d'escalier afin d'améliorer l'injection d'électrons dans la couche conductrice (60) de la structure de grille flottante ou dans la première couche de silicium (51), en fonction de la manière dont la couche conductrice de la grille flottante et la première couche de silicium sont polarisées.

2. Cellule de mémoire non volatile selon la revendication 1, **caractérisée en ce que** les sections (41, 42) du substrat de silicium dopé (4) sont deux sections séparées électriquement (41, 42) se trouvant sur une région (2) dont le dopage est opposé à celui du substrat (4), lesdites sections étant séparées par le composant isolé (20) de sorte que les deux sections (41, 42) puissent être polarisées différemment.

3. Cellule de mémoire non volatile selon l'une quelconque des revendications 1 ou 2, **caractérisée en ce que** la première section (41) du substrat de silicium dopé (4) a une forme de marche d'escalier.

4. Cellule de mémoire non volatile selon l'une quelconque des revendications 1 à 3, **caractérisée en ce que** l'angle de la forme de marche d'escalier formé dans la couche diélectrique (60) de la structure de grille flottante est compris entre 30° et 90° lorsque mesuré depuis une direction parallèle à la surface du substrat.

5. Cellule de mémoire non volatile selon l'une quelconque des revendications 1 à 3, **caractérisée en ce que** l'angle de la forme de marche d'escalier forme un Z.

6. Cellule de mémoire non volatile selon l'une quelconque des revendications 1 à 5, **caractérisée en ce que** la seconde couche de silicium (52) est un conducteur électrique d'un condensateur, l'autre conducteur électrique étant la couche conductrice (61) de la structure de grille flottante.

7. Cellule de mémoire non volatile selon l'une quelconque des revendications 1 à 6, **caractérisée en ce que** le substrat de silicium (4) est un puits dopé P.

8. Cellule de mémoire non volatile selon l'une quelconque des revendications 1 à 7, **caractérisée en ce que** les régions de drain (81) et de source (80) du transistor de sélection sont dopées N+.

9. Cellule de mémoire non volatile selon l'une quelconque des revendications 1 à 8, **caractérisée en ce que** les deux sections (41, 42) du substrat de silicium et le composant isolé (20) se trouvent sur une région de puits dopée N profonde (2) afin d'isoler électriquement les deux sections du substrat de silicium.

10. Cellule de mémoire non volatile selon l'une quelconque des revendications 1 à 9, **caractérisée en ce qu'**une région de puits dopée N (3) est formée entre le composant isolé (20) et la région de puits dopée N profonde (2), ladite région de puits dopée N (3) étant également comprise entre les deux sections (41, 42) du substrat de silicium de puits dopé P.

11. Cellule de mémoire non volatile selon l'une quelconque des revendications 1 à 10, **caractérisée en ce que** la couche conductrice (71) de la structure de grille et la couche conductrice (61) de la structure de grille flottante sont en silicium polycristallin.

12. Cellule de mémoire non volatile selon l'une quelconque des revendications 1 à 11, **caractérisée en ce que** le composant isolé (20), la couche diélectrique (70) de la structure de grille et la couche diélectrique (60) de la structure de grille flottante sont en oxyde de silicium.

13. Cellule de mémoire non volatile selon l'une quelconque des revendications 1 à 12, **caractérisée en ce que** l'épaisseur de la couche diélectrique (60) d'au moins la structure de grille flottante est constante, la valeur de l'épaisseur étant comprise entre 80 et 200 angstrôms.

14. Procédé pour fabriquer une cellule de mémoire non volatile selon les revendications 1 à 13, **caractérisé en ce qu'**il comprend les étapes suivantes :
a. fournir un substrat de silicium dopé P, appelé le substrat de base (1),
b. former une région de puits dopée N profonde (2) sur le substrat de base de silicium dopé P fourni,
c. former une région de puits dopée P (4) sur la région de puits dopée N profonde, ladite région de puits dopée P étant isolée électriquement du substrat de base grâce à la région de puits dopée N profonde,
d. fabriquer une tranchée afin de diviser physiquement la région de puits dopée P formée sur la région de puits dopée N profonde en deux régions de puits dopées P (41, 42), chaque région de puits dopée P étant appelée respectivement la première (41) et la seconde (42) section, la première section (41) ayant une forme de marche d'escalier,
e. insérer un élément diélectrique (20) à l'intérieur de la tranchée afin d'isoler électriquement les régions de puits dopées P (41, 42) l'une par rapport à l'autre,
f. former au moins deux couches de silicium dopées N+ (52, 51), la première couche de silicium (51) couvrant au moins en partie la première section (41) de la région de puits dopée P et la seconde couche de silicium (52) couvrant au moins en partie la seconde section (42) de la région de puits dopée P,
g. fabriquer une structure de grille, premièrement en déposant une couche diélectrique (70) sur la première section (41) de la région de puits dopée P où aucune couche de silicium dopée N+ (51) n'est présente, et deuxièmement en déposant une couche conductrice de silicium polycristallin (71) sur la couche diélectrique,
h. fabriquer une structure de grille flottante, premièrement en déposant une couche diélectrique (60) sur les deux couches de silicium dopées N+ (52, 51), et deuxièmement en déposant une couche conductrice de silicium polycristallin (61) sur la couche diélectrique,
i. implanter deux régions de source/drain N+ (80, 81) sur la première section (41) du substrat de puits dopé P, une région de source/drain N+ (80) étant adjacente à la première couche de silicium dopée N+ (51, 510), la structure de grille et les deux régions de source/drain N+ formant un transistor de sélection.

15. Procédé selon la revendication 14, **caractérisé en ce que** la structure de grille et la structure de grille flottante sont fabriquées en même temps.

16. Procédé pour programmer une cellule de mémoire non volatile selon les revendications 1 à 13, la cellule étant connectée à des moyens informatiques commandant ladite cellule et un générateur de puissance connecté à la cellule, **caractérisé par** l'injection d'électrons de la première couche de silicium (51) vers la couche conductrice (61) de la structure de grille flottante à travers le haut (T) de la marche d'escalier de la couche diélectrique (60), le procédé comprend l'étape d'application d'un potentiel positif à la seconde couche de silicium (52) grâce au générateur de puissance connecté à ladite couche, induisant la polarisation de la couche conductrice (61) de la structure de grille flottante via un effet de couplage capacitif.

17. Procédé pour programmer une cellule de mémoire non volatile selon la revendication 16, les deux sections (41, 42) du substrat de silicium (4) étant séparées électriquement, **caractérisé en ce que** le procédé comprend une étape additionnelle consistant à appliquer un potentiel négatif à la première section (41) du substrat de silicium et à la région de drain (81) du transistor de sélection grâce au générateur de puissance connecté à ladite première section du substrat de silicium et à la région de drain du transistor de sélection, induisant le flux d'électrons de la région de drain (81) vers la région de source (80) du transistor de sélection, ledit flux d'électrons polarisant négativement la région de drain (510) formée dans la première couche de silicium (51) adjacente à la région de source (80) du transistor de sélection.

18. Procédé pour effacer une cellule de mémoire non volatile selon les revendications 1 à 13, la cellule étant connectée à des moyens informatiques commandant ladite cellule et un générateur de puissance connecté à la cellule, **caractérisé par** l'injection d'électrons de la couche conductrice (61) de la structure de grille flottante vers la première couche de silicium (51) à travers le bas (B) de la marche d'escalier de la couche diélectrique (60), le procédé comprend l'étape d'application d'un potentiel positif à la couche conductrice (71) de la structure de grille et à la région de drain (81) du transistor de sélection grâce au générateur de puissance connecté à ladite couche conductrice (71) de la structure de grille et à la région de drain (81) du transistor de sélection, induisant la polarisation positive de la région de drain (510) formée dans la première couche de silicium (51) adjacente à la région de source (80) du transistor de sélection.

19. Procédé pour effacer une cellule de mémoire non volatile selon la revendication 18, les deux sections (41, 42) du substrat de silicium (4) étant séparées électriquement, **caractérisé en ce que** le procédé comprend une première étape consistant à appliquer un potentiel négatif à la seconde couche de silicium (52) et à la seconde section (42) du substrat de silicium grâce au générateur de puissance connecté à ladite couche et à la section du substrat de silicium, induisant la polarisation de la couche conductrice (61) de la structure de grille flottante via un effet de couplage capacitif.

20. Procédé pour lire une cellule de mémoire non volatile selon les revendications 1 à 13, **caractérisé par** la mesure du potentiel électrique de la couche conductrice (61) de la structure de grille flottante grâce au transistor de lecture, la région de drain (81) et la couche conductrice (71) du transistor de sélection étant polarisées positivement grâce au générateur de puissance connecté à la fois à la région de drain et à la couche conductrice du transistor de sélection.

21. Dispositif de mémoire non volatile, **caractérisé en ce qu'**il comprend une pluralité de cellules de mémoire non volatile interconnectées concernant l'une quelconque des revendications 1 à 13.
